Europäisches Patentamt

European Patent Office

Office européen des brevets

(11) Veröffentlichungsnummer : **0 063 673**
**B1**

(12) # EUROPÄISCHE PATENTSCHRIFT

(45) Veröffentlichungstag der Patentschrift :
15.05.85

(51) Int. Cl.⁴ : **H 02 M   1/08**, H 03 L   7/14

(21) Anmeldenummer : **82100391.0**

(22) Anmeldetag : **21.01.82**

(54) **Schaltung zum Erzeugen einer sinusförmigen Synchronisierspannung für die Zündung von Thyristoren.**

(30) Priorität : 22.04.81 CH 2623/81

(43) Veröffentlichungstag der Anmeldung :
03.11.82 Patentblatt 82/44

(45) Bekanntmachung des Hinweises auf die Patenterteilung : 15.05.85 Patentblatt 85/20

(84) Benannte Vertragsstaaten :
**AT BE CH DE FR GB IT LI NL SE**

(56) Entgegenhaltungen :
US-A- 3 573 649
US-A- 3 903 482
US-A- 4 042 873
US-A- 4 063 188
US-A- 4 101 844
INTERNATIONAL   JOURNAL   OF   ELECTRONICS,
Band 47, Nr. 2, August 1979, Seiten 139-145, London,
G.B. S.A.K. BHAT et al.: "A simple equidistant firing
delay scheme for 3-phi thyristor converters"

(73) Patentinhaber : **CONTRAVES AG**
**Schaffhauserstrasse 580**
**CH-8052 Zürich (CH)**

(72) Erfinder : **Schwager, Anton**
**Im Lindenhof 13**
**CH-8307 Effretikon (CH)**
Erfinder : **Suter, Hans-Jörg**
**Angelrain 525**
**CH-8185 Winkel (CH)**

**Beschreibung**

Die Erfindung betrifft eine Schaltung zum Erzeugen einer sinusförmigen Synchronisierspannung für die Zündung von Thyristoren im Stromregelkreis eines Antriebes für einen Elektromotor.

In Thyristor-Antrieben ist es bekannt, die Synchronisierspannung für die Zündung der Thyristoren von demselben Speisungsnetz zu beziehen, aus welchem der Antriebsstrom bezogen wird. Dies ist jedoch bei Hochleistungsantrieben, die zum Beispiel in verschiedenen militärischen Geräten eingesetzt und von kleinen 400-Hz-Generatoren der im Flugzeugbau verwendeten Art gespeist werden, zumindest aus folgenden Gründen nicht möglich :

— In den betrachteten Geräten variiert die Netzfrequenz stark, insbesondere wenn der Generator mit einer als Energiespeicher wirkenden Schwungscheibe versehen ist : die Lieferung der Antriebsleistung und die Aufnahme der Bremsleistung durch den Generator kann Schwankungen der Netzfrequenz zwischen etwa 350 und 450 Hz hervorrufen.

— Weil in den betrachteten Geräten die Spitzenlast im wesentlichen aus mit dem Elektromotor belasteten Thyristor-Brückenschaltungen besteht und das betrachtete Speisungsnetz mit dem erwähnten kleinen Generator und den Zuleitungen eine höhere Induktanz aufweist als übliche Netze wie zum Beispiel das einen üblichen Antrieb speisende Stadtnetz, entsteht beim Einschalten und beim Lastwechsel eine viel grössere Schwankung der Netzspannung im Speisungsnetz der betrachteten Geräte als in üblichen Netzen. (Im nachstehenden wird unter Schwankung eine im wesentlichen die Amplitude betreffende Störung der Netzspannung verstanden).

— Bei den Kommutierungseinbrüchen der Spannung an den Thyristoren ist das Produkt Hub x Zeitdauer für einen Spannungseinbruch unter anderem proportional zur Frequenz und zur Induktanz des Speisungsnetzes sowie zum Laststrom, daher ist das Produkt Hub x Zeitdauer mit dem betrachteten Speisungsnetz zu ca. 400 Hz wesentlich grösser als mit einem Netz zu 50 Hz und zudem noch stark last- bzw. Stromabhängig. Der Grundwelle der unverzerrten Netzspannung überlagert sich infolge der Kommutierungseinbrüche eine nicht sinusförmige Welle, deren Grundwelle gegenüber der unverzerrten Netzspannung in Abhängigkeit des Stromes, das heisst des Zündwinkels, phasenverschoben ist : die resultierende Grundwelle der Netzspannung ist gegenüber der Grundwelle der unverzerrten Netzspannung um einen variablen Phasenwikel, der bis zu + 20° betragen kann, verschoben. Unter solchen Umständen versagen die bekannten einfachen Filterschaltungen für die Extraktion einer sinusförmigen Synchronisierspannung aus der resultierenden verzerrten Netzspannung. (Im nachstehenden wird unter Verzerrung eine im wesentlichen den sinusförmigen Verlauf und/oder die Phase betreffende Störung der Netzspannung verstanden).

Es ist Aufgabe der Erfindung, eine Synchronisierspannung der eingangs erwähnten Art zu erzeugen, welche zur unverzerrten aber gegebenenfalls schwankenden Netzspannung phasen- und amplitudenstarr verriegelt bleibt, wenn unter anderem der Zündwinkel, der Laststrom, die Netzfrequenz, die Netzspannung und/oder die Form der Netzwelle variieren.

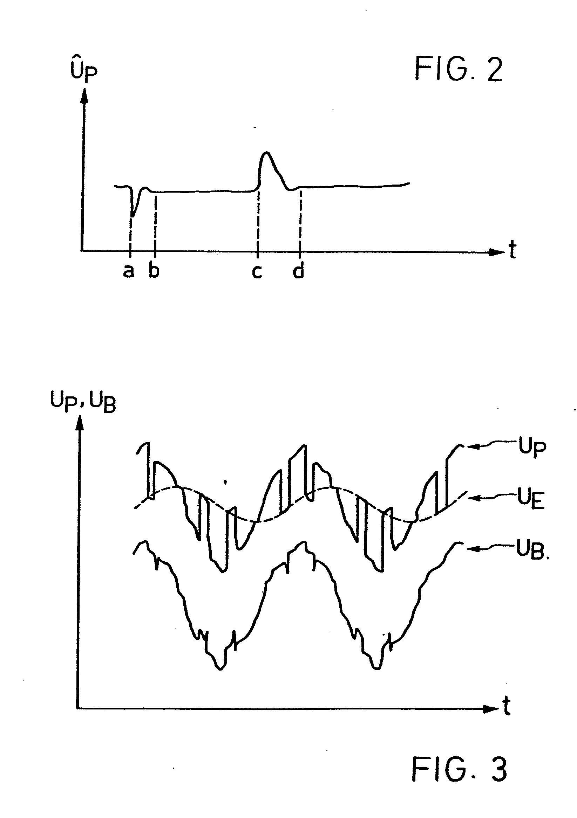

Im US-Patent Nr. 4042873 wird eine Schaltung der eingangs genannten Art vorgeschlagen, die einen Phasenregelkreis (PLL, phase-locked-loop) enthält, dessen Ausgangsspannung mit der Netzspannung frequenz- und phasenstarr verbunden ist und als Synchronisierspannung dient. Um trotz Schwankungen der Netzspannung den richtigen Zeitpunkt der Zündimpulse für die Thyristoren zu gewährleisten, wird im genannten US-Patent vorgeschlagen, aus der Ausgangsspannung des PLL eine Sägezahn-Funktion und daraus die Zündimpulse zu erzeugen, wobei der Einfluss von Frequenzänderungen kompensiert wird. Diese Schaltung vermag jedoch nicht den Einfluss der Kommutierungseinbrüche zu kompensieren : letztere verursache — wie im vorstehenden sowie weiter unten im Zusammenhang mit Fig. 2 erläutert wird — eine variable und unter Umständen grosse Phasenverschiebung der resultierenden Netzspannung gegenüber der unverzerrten Netzspannung, was die Phasenlage der Zündimpulse in bezug auf die unverzerrte Netzspannung auf unerwünschte Weise verschiebt, da der PLL auf die resultierende, verzerrte Netzspannung einrastet.

In INTERNATIONAL JOURNAL OF ELECTRONICS, 1979, Vol. 47, n° 2, pp. 139-145 wird eine weitere Schaltung der eingangs genannten Art vorgeschlagen, die ebenfalls einen PLL enthält, dessen Ausgangsspannung mit der Netzspannung frequenz- und phasenstarr verbunden ist und zur Erzeugung der Zündimpulse — hier mit Hilfe der Digitaltechnick — verwendet wird. Auch bei dieser Schaltung wird der Einfluss von Schwankungen und Frequenzänderungen der Netzspannung beseitigt, nich jedoch der Einfluss der Kommutierungseinbrüche, da auch hier die resultierende, verzerrte Netzspannung als Bezugsspannung für das Einrasten des PLL dient.

Beim Vorkommen von Kommutierungseinbrüchen in der Netzspannung ändert sich diese mehrmals in einer Periode sprunghaft, was die bereits erwähnte Phasenverschiebung verursacht. Es ist zwar bekannt, zum Beispiel aus dem US-Patent Nr. 3903482, einen PLL gegen Aenderungen seiner Bezugsspannung (hier der Netzspannung) zu stabilisieren : zu diesem Zweck wird mit Hilfe von Schaltern und Speichern die seinem Nachlaufoscillator (VCO, voltage-controlled-oscillator) eingegebene Spannung konstantgehalten, wenn die im PLL erzeugte Steuerspannung des VCO sich schnell ändert und solange sie von der am VCO konstantgehaltenen Spannung abweicht. Diese Schaltung ist dazu bestimmt, im Fernmeldewesen die Wirkung von zum Beispiel durch Interferenzen verursachten Phasenänderungen einer empfangenen Welle zu eliminieren : typisch sind 10 bis 600 Sekunden dauernde Phasenverschiebungen der empfangenen Welle zu überbrücken. Die Schaltung nach dem genannten US-Patent ist jedoch nicht verwendbar, wenn es gilt, die Wirkung von Kommutierungseinbrüchen in einer Netzspannung zu eliminieren : der PLL würde auf die resultierende, verzerrte Netzspannung einrasten, weil die im PLL erzeugte Steuerspannung des VCO am Ausgang eines Tiefpasses erscheint und daher dem Erscheinen und Verschwinden der Kommutierungseinbrüche gar nicht folgen kann.

Andere Schaltungen mit einer Kombination von PLL, Schalter und Speicher sind zum Beispiel aus den US-Patenten Nr. 3573649, 4063188 und 4101844 bekannt : sie bezwecken, den Betrieb des PLL nach einem Ausfall der zugeführten Bezugsspannung auf derselben Frequenz aufrechtzuerhalten, also einen Speicher für die Frequenz einer kurzzeitig empfangenen Welle zu schaffen. Zu diesem Zweck werden die Schalter und Speicher zu einem vorbestimmten Zeitpunkt nach dem Einrasten des PLL betätigt, um die seinem VCO eingegebene Spannung konstantzuhalten. Auch mit solchen Schaltungen wird die Wirkung von Kommutierungseinbrüchen der Netzspannung nicht eliminiert, weil auch hier der PLL auf die resultierende, verzerrte Netzspannung einrasten würde.

Die erfinderische Lösung der Aufgabe beruht auf der Erkenntis, dass zur Verwendung als Synchronisierspannung eine Sinusspannung zu erzeugen ist, welche die unverzerrte Netzspannung während der Kommutierungseinbrüche unter Berücksichtigung der beim Einschalten oder noch beim Lastwechsel wegen der Zeitkonstante des Reglers entstehenden Spannungsschwankungen nachbildet.

Zur Lösung der Aufgabe ist eine Schaltung der eingangs erwähnten Art gekennzeichnet durch die im Anspruch angegebene Kombination von Merkmalen.

Mit der erfindungsgemässen Lösung wird erreicht, dass der PLL von der Netzspannung synchronisiert wird, solange diese im wesentlichen unverzerrt bleibt, so dass die Synchronisierspannung mit der Netzspannung auch bei Frequenzänderungen phasenstarr verbunden bleibt. Wenn jedoch eine Verzerrung der Netzspannung auftritt, wird der PLL auf sich selbst rückgekoppelt so dass er die Phase der unverzerrten Netzspannung beibehält, bis die Verzerrung der Netspannung aufhört, was infolge der Kommutierungseinbrüche bis zu 200 us dauern kann : dabei wird das Verhältnis der Amplitude der Synchronisierspannung zur Amplitude der resultierenden Grundwelle der gegebenenfalls schwankenden Netzspannung konstant gehalten.

Der Zündwinkel der Thyristoren bleibt also von Verzerrungen der Netzspannung sowie von deren Amplituden- und Frequenzänderungen unbeeinflusst. Ferner wird gewährleistet, dass vom Einschalten der Speisung bis zum Einrasten der Ausgangsspannung des PLL auf die Phase der unverzerrten Netzspannung letztere an den Bezugsfrequenz-Eingang des PLL angelegt wird, damit das Einrasten überhaupt stattfinden kann.

Im folgenden wird nun die Erfindung unter Bezugnahme auf die Zeichnung näher beschrieben. Es zeigen :

Figur 1 ein Blockschaltbild der erfindungsgemässen Schaltung,

Figur 2 eine Nachzeichnung eines Oszillogramms zur Veranschaulichung des Zeitverlaufs einer Netzspannung bei Lastwechsel, und

Figur 3 eine Nachzeichnung eines Oszillogramms zur Veranschaulichung des Zeitverlaufs einer Netzspannung bei Kommutierungseinbrüchen sowie einer entsprechenden am Bezugsfrequenz-Eingang des PLL anstehenden Spannung.

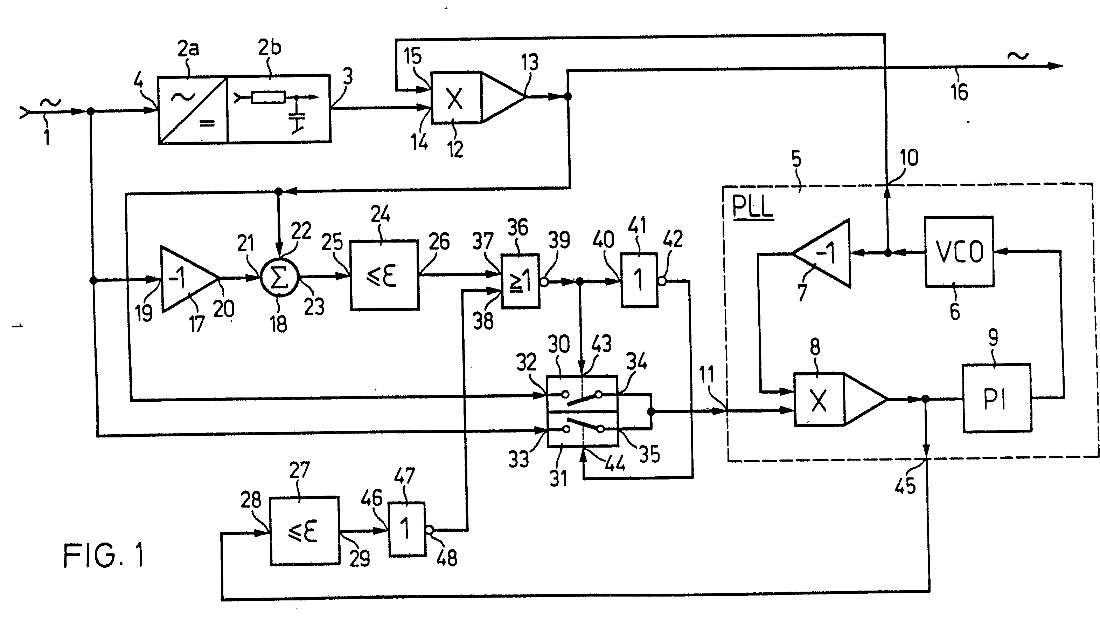

In Fig. 1 wird ein Blockschaltbild einer Schaltung zum Erzeugen einer sinusförmigen Synchronisierspannung für die Zündung von Thyristoren im Stromregelkreis eines von einem Speisungsnetz gespeisten Antriebes für einen Elektromotro dargestellt. Die dargestellten Blockbilder stehen anstelle der detaillierten Zeichnung an sich bekannter Schaltungsteile, die zum Beispiel im Buch von U. Tietze und Ch. Schenk « Halbleiter-Schaltungstechnik » (4. Auflage, Springer-Verlag, 1978) beschrieben werden : im nachfolgenden wird unter der Kurzbezeichnung « TS » auf dieses Buch verwiesen, und jeweils die Stelle angegeben, an welcher der betreffende Schaltungsteil beschrieben wird.

Die Schaltung wird an einen Phasenleiter 1 des Speisungsnetzes angeschlossen ; die am Phasenleiter 1 anstehende Netzspannung $U_p$ wird mit Bezug auf einen nicht eingezeichneten Nulleiter definiert. Bei einem dreiphasigen Speisungsnetz werden je eine Schaltung an je einen der drei Phasenleiter angeschlossen.

Der mit 2a und 2b bezeichnete Schaltungsteil ist ein Vollweggleichrichter (2a) mit Tiefpass 1. Ordnung (2b) zum Beispiel der in « TS » auf Seiten 656-657 und Abbildung 25.11 beschriebeñ Art. Am Ausgang 3 dieses Schaltungsteiles erscheint der Betragsmittelwert $U_M = |\overline{U_P}|$ der an seinen Eingang 4 angelegten, vom Phasenleiter 1 zugeleiteten Netzspannung $U_P$ ; $U_M$ ist eine reine Gleichspannung, eine eventuell übrigbleibende Welligkeit kann durch Verwendung eines Tiefpasses 2. Ordnung anstelle des Tiefpasses 1. Ordnung auf einen vernachlässigbaren Wert reduziert werden, was an sich bekannt ist.

Der mit 5 bezeichnete Schaltungsteil ist ein Phasenregelkreis (PLL, phase-locked loop) zum Beispiel der in « TS » auf Seiten 683-691 und Abbildungen 26.20, 26.24 und 26.26 beschriebenen Art, mit einem Nachlaufoszillator 6 (VCO, voltage-controlled oscillator), einem invertierenden Verstärker 7 mit einem Verstärkungsfaktor von zum Beispiel 1, einem Multiplizierer 8 und einem Regler 9 mit Proportional- und Integralwirkung. Am Ausgang 10 des PLL 5 erscheint die vom VCO 6 erzeugte sinusförmige Spannung, welche mit der an den Bezugsfre-quenz-Eingang 11 des PLL 5 angelegten Spannung frequenz- und phasengleich verriegelt ist.

Der mit 12 bezeichnete Schaltungsteil ist ein Vierquadranten-Multiplizierer zum Beispiel der in « TS » auf Seiten 226-230 und Abbildung 14.41 beschriebenen Art (auch der Multiplizierer 8 kann ein Multiplizierer dieser Art sein). Am Ausgang 13 des Multiplizierers 12 erscheint eine Spannung, die das Produkt der seinen Eingängen 14 und 15 zugeleiteten Spannungen ist, nämlich des vom Ausgang 3 zugeleiteten Betragsmittelwerts $U_M$ und der vom Ausgang 10 zugeleiteten Sinusspannung. Der dem Multiplizierer 12 inhärente Verstärkungsfaktor wird so gewählt oder eingestellt, dass die Spannungen am Eingang 15 und am Ausgang 13 einander gleich sind, wenn die Spannung $U_M$ ihren Sollwert aufweist, was der Fall ist, wenn die Netzspannung $U_P$ auf dem Phasenleiter 1 rein sinusförmig ist und ihr Scheitelwert einen vorbestimmten Sollwert aufweist, zum Beispiel bei 115 Volt Wechselspannung. Die Spannung am Ausgang 13 ist im wesentlichen sinusförmig, sie wird als Synchronisierspannung für die Zündung der Thyristoren verwendet und zu diesem Zweck auf einer Leitung 16 abgegeben.

Der mit 17 und 18 bezeichnete Schaltungsteil ist ein Subtrahierer zum Beispiel der in « TS » auf Seiten 190-191 und Abbildung 11.2 beschriebenen Art. Ein Rechenverstärker 17 mit einem Verstärkungsfaktor von − 1 lässt die an seinen Eingang 19 angelegte Spannung mit gleichem Absolutwert und umgekehrten Vorzeichen an seinem Ausgang 20 erscheinen ; der Eingang 19 ist mit dem Phasenleiter 1 verbunden. Ein Addierer 18 bildet die Summe der an seinen Eingängen 21 und 22 angelegten Spannungen, das Resultat der Addition erscheint an seinem Ausgang 23 ; der Eingang 21 ist mit dem Ausgang 20 und der Eingang 22 mit dem Ausgang 13 verbunden. Folglich erscheint am Ausgang 23 die Differenz zwischen der Netzspannung und der Synchronisierspannung mit einem Vorzeichen, das hier nicht von Belang ist.

Der mit 24 bezeichnete Schaltungsteil ist ein Fensterkomparator zum Beispiel der in « TS » auf Seite 413 und Abbildung 17.24 beschriebenen Art. Seinem Eingang 25 wird die am Ausgang 23 erscheinende Spannungsdifferenz zugeleitet. An seinem Ausgang 26 erscheint ein logisches Signal « 1 », wenn die Spannung an seinem Eingang 25 zwischen den beiden Grenzwerten + ε und − ε liegt, wobei ε eine vorgegebene, im Vergleich zum Soll-Scheitelwert von $U_p$ sehr kleine Spannung ist : dieses logische Signal « 1 » wird als erstes Steuersignal bezeichnet. Folglich erscheint das erste Steuersignal, wenn die Synchronisierspannung und die Netzspannung im wesentlichen einander gleich sind, das heisst ausserhalb der Zeiten, wo ein Kommutierungseinbruch auftritt.

Der mit 27 bezeichnete Schaltungsteil ist ein Fensterkomparator derselben Art. Seinem Eingang 28 wird die im PLL 5 am Ausgang des Multiplizierers 8 erscheinende Spannung, die bekanntlich dem Nachlauffehler des PLL proportional ist, über einen Ausgand 45 des PLL 5 zugeleitet. Folglich erscheint am Ausgang 29 des Fensterkomparators 27 ein logisches Signal « 1 », wenn die am Eingang 11 und am Ausgang 10 des PLL 5 anstehenden Spannungen im wesentlichen frequenz- und phasengleich sind : dann ist der PLL eingerastet, was auch bedeutet, dass die dem Eingang 11 zugeführte Spannung frequenz- und phasengleich mit der Synchronisierspannung ist. Das entsprechende logische Signal « 1 » wird als zweites Steuersignal bezeichnet.

Der Ausgang 29 des Fensterkomparators 27 ist mit dem Eingang 46 eines Invertierers oder NICHT-Tors 47 verbunden, so dass am Ausgang 48 des Invertierers 47 das logische Komplement des zweiten Steuersignals erscheint.

Die mit 30 und 31 bezeichneten Schalter sind elektronische Serien-Schalter, zum Beispiel CMOS-Serien-Schalter der in « TS » auf Seiten 398-399 und Abbildung 17.4 beschriebenen Art. Jeder dieser Schalter wird leitend, wenn sein Steuereingang ein logisches Signal « 1 » erhält. Der Eingang 32 des Schalters 30 ist mit dem Ausgang 13 verbunden, er erhält daher die Synchronisierspannung. Der Eingang 33 des Schalters 31 ist mit dem Phasenleiter 1 verbunden, er erhält daher die Netzspannung. Der Ausgang 34 des Schalters 30 und der Ausgang 35 des Schalters 31 sind miteinander verbunden, so dass die beiden Schalter 30 und 31 zusammen einen Umschalter bilden, dessen gemeinsamer Ausgang 34, 35 mit dem Eingang 11 des PLL 5 verbunden ist. Wie im nachfolgenden erläutert wird, werden die Schalter 30 und 31 gegenläufig gesteuert, so dass in einem ersten Schaltzustand der Schalter 30 sperrt und der Schalter 31 leitet, während in einem zweiten Schaltzustand der Schalter 30 leitet und der Schalter 31 sperrt : folglich wird im ersten Schaltzustand die Netzspannung und im zweiten Schaltzustand die Synchronisierspannung zum Bezugsfrequenz-Eingang 11 des PLL 5 zugeleitet.

Mit 36 wird ein NOR-Tor bezeichnet, dessen einer logischer Eingang 37 mit dem Ausgang 26 und dessen anderer logischer Eingang 38 mit dem Ausgang 48 verbunden ist. Am Ausgang 39 des NOR-Tors 36 erscheint daher ein logisches Signal « 1 » nur dann, wenn das erste Steuersignal fehlt und gleichzeitig das zweite Steuersignal vorhanden ist. Der Ausgang 39 ist mit dem Eingang 40 eines Invertierers oder NICHT-Tors 41 verbunden, so dass am Ausgang 42 des Invertieres 41 das logische Komplement des Signals am Ausgang 39 des NOR-Tors 36 erscheint. Zudem ist der Ausgang 39 mit dem Steuereingang 43 des Schalters 30 und der Ausgang 42 mit dem Steuereingang 44 des Schalters 31 verbunden. Fehlt also das erste Steuersignal während das zweite Steuersignal vorhanden ist, so wird der Schalter 30 leitend, was dem zweiten Schaltzustand entspricht ; bei allen anderen Kombinationen von Steuersignalen wird der Schalter 31 leitend, was dem ersten Schaltzustand entspricht.

Der Zweck der Schaltung wird erkennbar, wenn die wesentlichen Störungen der Netzspannung erläutert werden. In Fig. 2 ist der Zeitverlauf einer Netzspannung dargestellt, während durch Lastwechsel verursachte Schwankungen der Netzspannung stattfinden. Auf der Abszisse wurde die Zeit t eingetragen. Auf der Ordinate wurde der momentane obere Scheitelwert $\hat{U}_p$ der Netzspannung $U_p$ eingetragen. In Fig. 2 erscheint also die obere Umhüllende der Netzspannung ; sie wurde vom Bildschirm eines Oszillographen abgezeichnet. Vor dem Zeitpunkt a beträgt der Scheitelwert $\hat{U}_p$ seinen Sollwert von 170 Volt, die Frequenz ist 400 Hz. Beim Zeitpunkt a wird eine Last von 120 KVA eingeschaltet : von a bis b ist eine transiente Störung der Amplitude sichtbar, die ca. 30 ms dauert und $\hat{U}_p$ zeitweise um ca. 40 Volt absinken lässt ; von b bis c bleibt die Last eingeschaltet, $\hat{U}_p$ bleibt zwar etwa konstant, jedoch ca. 7 Volt tiefer als vor dem Zeitpunkt a. Beim Zeitpunkt c wird die Last ausgeschaltet : von c bis d ist eine transiente Störung der Amplitude sichtbar, die ca. 80 ms dauert und $\hat{U}_p$ zeitweise um ca. 50 Volt ansteigen lässt. Der Verlauf nach dem Zeitpunkt d ist dem Verlauf vor dem Zeitpunkt a äquivalent. Solchen Störungen der Amplitude der Netzspannung muss die Amplitude der Synchronisierspannung folgen, weil sonst der Zeitpunkt der Thyristoren-Zündung verschoben wird : die gewünschte Korrektur der Synchronisierspannung wird durch die Bildung des Produkts im Multiplizierer 12 bewerkstelligt.

In Fig. 3 ist der Zeitverlauf einer Netzspannung dargestellt, während durch Kommutierungseinbrüche verursachte Verzerrungen stattfinden. Wiederum wurde auf der Abszisse die Zeit t eingetragen. Auf der Ordinate wurde der momentane Wert $U_p$ der Netzspannung eingetragen : es ist ersichtlich, dass der Zeitverlauf von $U_p$ eine von den Kommutierungseinbrüchen unterbrochene Sinus-Grundwelle ist. Bemerkenswert ist aber, dass der Wert von $U_p$ während der Kommutierungseinbrüche einer gestrichelt dargestellten Umhüllenden $U_E$ entspricht, die auch eine Sinus-Grundwelle ist : die Grundwellen von $U_p$ und $U_E$ sind jedoch, wie aus Fig. 3 ersichtlich, deutlich phasenverschoben, so dass die Resultierende, das heisst die als effektive Netzspannung wirkende Summe der beiden Grundwellen, ebenfalls gegenüber der Grundwelle von $U_p$ phasenverschoben ist : Messungen haben ergeben, dass die effektive Netzspannung um ± 20° gegenüber der Grundwelle von $U_p$ phasenverschoben sein kann. Der Verlauf von $U_p$ wurde vom Bildschirm eines Oszillographen abgezeichnet ; die Kommutierungseinbrüche entsprechen der Speisung eines stillstehenden Motors mit einem Strom von 300 A unter 120 Volt und 400 Hz (Sollwerte). Auf demselben Bildschirm gleichzeitig dargestellt und in Fig. 3 ebenfalls abgezeichnet, ist der Zeitverlauf der an den Bezugsfrequenz-Eingang 11 des PLL 5 angelegten Spannung $U_B$ sichtbar. Es ist ersichtlich, dass die Grundwelle von $U_B$ mit der Grundwelle von $U_p$ phasengleich ist, d. h. die von dem Kommutierungseinbrüchen verursachte Phasenverschiebung hat keine Wirkung auf die Phasenlage von $U_B$. Dies wird auf folgende Weise erreicht :

Während eines Kommutierungseinbruchs ist die Differenz der Momentanwerte der Netzspannung auf der Leitung 1 und der Synchronisierspannung am Ausgang 13 des Multiplizierers 12 nicht mehr sehr klein. Dies wird im Subtrahierer 17, 18 festgestellt, und das erste Steuersignal fällt während der Zeitdauer des Kommutierungseinbruches aus. Dies hat zur Folge, dass der auf sich selbst rückgekoppelte PLL nun als Speicher für die Phasenlage der Netzspannung wirkt, bis die Synchronisierung des PLL mit der Netzspannung wieder erfolgen kann, nämlich sobald der Kommutierungseinbruch beendet ist. Die Wirkung des Umschalters 30, 31 ist bei einem Vergleich der Kurven in Fig. 3 erkennbar : die Kommutierungseinbrüche werden durch den Umschalter 30, 31 aus der Kurve $U_p$ « herausgeschnitten » und durch unverzerrte, der Synchronisierspannung « entnommene » Kurvenabschnitte « ersetzt », auf diese Weise wird die Kurve $U_B$ « zusammengestückt ». Damit wird erreicht, dass der PLL 5 mit einer unverzerrten Netzspannung synchronisiert wird, die eigentlich gar nicht auf dem Phasenleiter 1 vorhanden ist, sondern erst in der Form von $U_B$ geschaffen werden muss.

Gleich nach dem Einschalten des Speisungsnetzes liefert der VCO 6 des PLL 5 eine sinusförmige Spannung mit der gewünschten Amplitude. Die Frequenz dieser PLL-Spannung weicht jedoch von der Netzfrequenz meist erheblich ab : solange der PLL nicht auf die Netzfrequenz eingerastet ist, fehlt das zweite Steuersignal, was bewirkt, dass die Netzspannung auf den Bezugsfrequenz-Eingang des PLL eingegeben wird. Der PLL kann also auf die Netzfrequenz einrasten, worauf das zweite Steuersignal erscheint und den beschriebenen Umschaltvorgang bei Kommutierungseinbrüchen freigibt.

## Patentanspruch

Schaltung zum Erzeugen einer sinusförmigen Synchronisierspannung (16) für die Zündung von Thyristoren im Stromregelkreis eines von einem Speisungsnetz (1) gespeisten Antriebes für einen Elektromotor, gekennzeichnet durch die Kombination folgender Merkmale :

— die Synchronisierspannung (16) wird als Produkt (12) der Ausgangsspannung (10) eines PLL (phase-locked loop) (5) mit dem Betragsmittelwert (3) der Netzspannung (4) des Speisungsnetzes (1) gebildet, derart, dass die Ausgangsspannung des PLL (5) gleich der Synchronisierungsspannung (16) ist, wenn die Netzspannung (4) sinusförmig ist und ihr Scheitelwert (3) einen vorbestimmten Sollwert aufweist ;

— die Synchronisierspannung (16) wird mit der Netzspannung (4) verglichen (17, 18, 24), und es wird ein erstes Steuersignal (26) erzeugt, wenn die Netzspannung (4) im wesentlichen gleich der Synchronisierspannung (16) ist ;

— ein Umschalter (30, 31) leitet in einem ersten Schaltzustand (31) die Netzspannung (4) und in einem zweiten Schaltzustand (30) die Synchronisierspannung (16) zum Bezugsfrequenz-Eingang (11) des PLL (5) ;

— die Phase der an den Bezugsfrequenz-Eingang (11) des PLL (5) angelegten Spannung wird mit der Phase der Ausgangsspannung (10) des PLL (5) verglichen (7, 8, 27), und es wird ein zweites Steuersignal (29) erzeugt, wenn der entsprechende Phasenunterschied im wesentlichen gleich Null ist ;

— der Umschalter (30, 31) wird von den beiden Steuersignalen gesteuert (26, 29, 36, 41), derart, dass sich der Umschalter beim Fehlen des ersten Steuersignals und gleichzeitigem Vorliegen des zweiten Steuersignals im zweiten Schaltzustand, anderenfalls im ersten Schaltzustand befindet.

### Claim

Circuit arrangement for producing a sinusoidal synchronising voltage (16) for the ignition of thyristors in the current regulation circuit of a drive for an electric motor fed from a supply system (1), characterised by the combination of the following features :

— the synchronising voltage (16) is formed as a product (12) of the output voltage (10) of a PLL (5) (phase locked loop) with the magnitude of the mean value (3) of the power supply voltage (4) of the supply system (1), so that the output voltage of the PLL (5) is equal to the synchronising voltage (16), when the power supply voltage (4) is sinusoidal and its peak value (3) has a specific desired value ;

— the synchronising voltage (16) is compared (17, 18, 24) with the power supply voltage (4), and a first control signal (26) is produced when the power supply voltage (4) is substantially equal to the synchronising voltage (16) ;

— a change-over switch (30, 31) conducts the power supply voltage (4) in a first switch state (31), and in a second switch state (30) the synchronising voltage (16), for the reference frequency input (11) of the PLL (5) ;

— the phase of the voltage applied at the reference frequency input (11) of the PLL (5) is compared (7, 8, 27) with the phase of the output voltage (10) of the PLL (5), and a second control signal (29) is produced when the corresponding phase difference is substantially equal to zero ;

— the change-over switch (30, 31) is controlled by the two control signals (26, 29, 36, 41) such that when the first control signal is missing and at the same time the second control signal is present, the change-over switch is in the second switch state, and is otherwise in the first switch state.

### Revendication

Circuit pour engendrer une tension de synchronisation sinusoïdale (16) pour l'allumage de thyristors dans le circuit de régulation de courant d'un entraînement, alimenté à partir d'un réseau d'alimentation (1), pour un moteur électrique, circuit caractérisé par la combinaison des caractéristiques suivantes :

— la tension de synchronisation (16) revêt la forme du produit (12) de la tension de sortie (10) d'un PLL (phase-locked loop) (5) par la valeur absolue moyenne (3) de la tension (4) du réseau d'alimentation (1), de sorte que la tension de sortie du PLL (5) est identique à la tension de synchronisation (16), lorsque la tension (4) du réseau est sinusoïdale et que sa valeur maximale (3) présente une valeur de consigne prédéterminée.

— la tension de synchronisation (16) est comparée (17, 18, 24) avec la tension (4) du réseau et un premier signal de commande (26) est obtenu lorsque la tension (4) du réseau est en pratique identique à la tension de synchronisation (16),

— un commutateur (30, 31) applique dans un premier état de commutation (31) la tension (4) du réseau, et dans un second état de commutation (30) la tension de synchronisation (16), à l'entrée (11) de fréquence de référence du PLL (5),

— la phase de la tension appliquée à l'entrée (11) de tension de référence du PLL (5) est comparée (7, 8, 27) à la phase de la tension de sortie (10) du PLL (5) et un second signal de commande (29) est obtenu lorsque la différence de phases correspondante est essentiellement nulle,

— le commutateur (30, 31) est commandé (26, 29, 36, 41) par les deux signaux de commande de sorte que le commutateur se trouve dans le second état de commutation en l'absence du premier signal de commande et en la présence simultanée du second signal de commande, et se trouve dans le premier état de commutation dans les autres cas.

FIG. 1

$\hat{U}_P$

FIG. 2

a  b        c    d        t

$U_P, U_B$

$U_P$

$U_E$

$U_B.$

t

FIG. 3